# EUROPÄISCHE PATENTSCHRIFT

(11) **EP 3 226 065 B1**
(45) Veröffentlichungstag und Bekanntmachung des Hinweises auf die Patenterteilung: **06.09.2023**
(21) Anmeldenummer: 16163152.8
(22) Anmeldetag: 31.03.2016
(51) Int. Cl.: G02B 27/10, H04N 9/31

(54) **LICHTMODUL UND VERFAHREN ZUR ÜBERWACHUNG VON LASERDIODEN IN EINEM LICHTMODUL**
LIGHT MODULE AND METHOD FOR MONITORING LASER DIODES IN A LIGHT MODULE
MODULE D'ECLAIRAGE ET PROCEDE DE SURVEILLANCE DE DIODES LASER DANS UN MODULE D'ECLAIRAGE

(43) Veröffentlichungstag der Anmeldung: 04.10.2017
(73) Patentinhaber: Fisba AG, 9016 St. Gallen (CH)
(72) Erfinder: Moser, Hansruedi, 9452 Hinterforst (CH); Spring, Patrick, 9403 Goldach (CH); Wäspi, Marcel, 9312 Häggenschwil (CH)
(74) Vertreter: Hepp Wenger Ryffel AG

(56) Entgegenhaltungen:
- EP-A1- 2 966 490
- WO-A1-2015/146071
- US-A1- 2011 205 501
- US-A1- 2011 261 326
- US-B1- 6 639 631
- US-B2- 6 879 395

## Beschreibung

Die Erfindung betrifft ein Lichtmodul sowie ein Verfahren zur Überwachung von Laserdioden in einem Lichtmodul, gemäss dem Oberbegriff der unabhängigen Ansprüche.

Es sind bereits Lichtmodule bekannt, bei denen Licht unterschiedlicher Wellenlängen in einem Strahl kombiniert wird und dann auf eine Projektionsfläche gelenkt wird.

Aus der WO 2012/163574 ist beispielsweise ein Projektionsmodul bekannt, welches drei Lichtquellen auf je einen halbreflektierenden Spiegel richtet, wobei das emittierte Licht aus den Lichtquellen durch die halbreflektierenden Spiegel zu einem Strahl kombiniert wird. Der kombinierte Strahl wird auf einen MEMS-Spiegel geführt, der den Lichtstrahl dann auf eine Projektionsoberfläche lenkt.

Um ein klares und scharfes Projektionsbild zu ermöglichen, dessen Farbe und Intensität nicht von der Umgebungs- und Systemtemperatur abhängt, wird das erzeugte Licht kontrolliert.

Dafür wird der kombinierte Strahl durch einen Strahlteiler geführt, der den kombinierten Strahl in einen Primärstrahl und einen Sekundärstrahl zerlegt. Der Primärstrahl wird zum Beispiel von einer ersten Oberfläche des Strahlteilers auf den MEMS-Spiegel geführt, der Sekundärstrahl von einer zweiten Oberfläche des Strahlteilers zu einer Photodiode geführt. Die Eigenschaften des Sekundärstrahls, wie zum Beispiel Lichtintensität, Wellenlängen, Modulationsgeschwindigkeit, Lichthomogenität, Divergenz oder Form lassen Rückschlüsse auf die Qualität des Primärstrahls zu.

Die Eigenschaften des Sekundärstrahls können daher in einem Regelkreis zum Nachjustieren der Lichtquellen verwendet werden.

Allerdings verursachen zusätzliche optische Elemente, wie der Strahlteiler und die Photodiode, zum einen Lichtverluste im Primärstrahl und zum anderen parasitäres Licht, das den Primärstrahl überlagern und stören kann.

Das aus dem Stand der Technik bekannte Lichtmodul ist sehr aufwendig und teuer in der Herstellung, da es der präzisen Montage eines Strahlteilers und einer Photodiode bedarf.

Die US 2011/205501 zeigt offenbart ein Lichtmodul mit einem einteiligen Strahlkombinierers, der die Lichtstrahlen von drei Laserdioden zusammenführt. Fehlgeleitetes Streulicht, das aus der Unvollkommenheit der dichroitischen Oberflächen resultiert, wird auf einen Sensor gerichtet, der in Kontakt mit einer unbeschichteten Oberfläche des Strahlkombinierers steht oder mit einem optischen Kleber daran fixiert ist.

Es ist daher Aufgabe der Erfindung, ein Lichtmodul sowie ein Verfahren zur Überwachung von Laserdioden in einem Lichtmodul zu schaffen, welches die Nachteile des Standes der Technik vermeidet. Insbesondere ist es Aufgabe der Erfindung, ein Verfahren und ein Lichtmodul zu schaffen, welches kostengünstig bereitstellbar ist.

Die Aufgabe wird mit den kennzeichnenden Merkmalen der unabhängigen Ansprüche gelöst.

Das erfindungsgemässe Lichtmodul zur Erzeugung von mehrfarbigem Licht umfasst mindestens zwei, bevorzugt drei, Laserdioden. Jeder Laserdiode ist eine Kollimierungsvorrichtung zur Kollimierung der emittierten Strahlung der jeweiligen Laserdiode zugeordnet.

Das Lichtmodul umfasst ausserdem eine Strahlkombinationsvorrichtung zum Kombinieren der emittierten Strahlung aus den jeweiligen Laserdioden.

Als Strahlkombinationsvorrichtung können dichroitische Filter vorgesehen sein, die beispielsweise für bestimmte Wellenlängen reflektierend und für andere Wellenlängen durchlässig sind. Mittels der Filter können in einen Lichtstrahl mit bestimmten Wellenlängen Strahlen mit weiteren Wellenlängen eingekoppelt werden.

Das Lichtmodul weist eine Photodiode zur Überwachung der von den 1 Laserdioden emittierten Strahlung auf.

Insbesondere ist ausserdem eine Strahlformungseinrichtung vorgesehen, die den von der Strahlkombinationsvorichtung kombinierten Strahl formt. Dabei kann ein asymmetrisches Strahlprofil, zum Beispiel mit ovalem Querschnitt und/oder mit ungleichen Fast- und Slow-Axen des Strahls, zu einem möglichst symmetrischen Strahlprofil, zum Beispiel mit rundem Querschnitt, geformt werden.

Als Strahlformungseinrichtung kann eine Prismenteleskop vorgesehen sein, bei dem ein Laserstrahl mit elliptischem Querschnitt, wie er typischerweise eine Kollimiervorrichtung verlässt, durch ein Prismenpaar in einen Strahl mit rundem Querschnitt transformiert wird.

Erfindungsgemäss ist die Photodiode derartig angeordnet, dass nur Streulicht auf die Photodiode trifft.

Als Streulicht wird Licht betrachtet, welches von optischen Komponenten des Lichtmoduls emittiert wird und das von dem bestimmungsgemässen Lichtpfad der optischen Komponenten abweicht.

Der bestimmungsgemässen Lichtpfad oder Strahlverlauf des Lichtmoduls beginnt bei den Lichtquellen und endet an einem Austrittsfenster des Lichtmoduls.

Jedes Element, das sich in dem bestimmungsgemässen Strahlverlauf befindet, emittiert den Grossteil des Lichts bestimmungsgemäss, das heisst leitet den Lichtstrahl durch, lenkt ihn um oder formt ihn und trägt zum primären Lichtstrahl des Lichtmoduls bei. Ein kleiner Teil des auftreffenden Lichts wird allerdings als parasitäres Licht vom bestimmungsgemässen Lichtpfad des Lichtmoduls weggelenkt, sei es aufgrund nicht ganz optimaler Justierung, sei es aufgrund nicht ganz idealer optischer Eigenschaften. Dazu gehören beispielweise Restreflexe an optischen Flächen.

Die Photodiode befindet sich also nicht im Strahlweg des Lichtmoduls und es ist keine optische Komponente vorgesehen, die nur dazu dient, einen Teil des primären Lichtstrahls in Richtung Photodiode abzuzweigen.

Vielmehr detektiert die Photodiode Licht, das nicht zur Lichtausbeute des Lichtmoduls und damit zum primären Lichtstrahl beiträgt und welches trotzdem ohnehin im Lichtmodul vorhanden ist.

Dieses Licht kann zur Kontrolle des Lichtmodules verwendet werden. Zur Kontrolle muss also keine Intensitätseinbusse in Kauf genommen werden.

Die Eigenschaften des Streulichts können für eine Überwachung des primären Lichtstrahls und/oder für eine Steuerung und/oder Regelung der Lichtquellen verwendet werden.

Bevorzugt wird Streulicht verwendet, das erst am Ende des Lichtpfades im Lichtmodul emittiert wird und daher Aufschluss über die Kombination der von den Lichtquellen ausgehenden Lichtstrahlen gibt.

Erfindungsgemäss umfasst das Lichtmodul mindestens eine Diffusorfläche zur Abgabe von homogenisiertem Streulicht.

Das in dem Lichtmodul erzeugte Streulicht ist zumeist gerichtet, wobei die Streurichtung im Detail nicht unbedingt vorhersehbar ist, da es sich gerade um eine nicht bestimmungsgemässe Lichtabgabe handelt. Um die Montage der Photodiode zu erleichtern, wird das Streulicht daher über eine Diffusorfläche geleitet. Dies dient zur Homogenisierung des Streulichts. Von einer Diffusorfläche abgegebenes Streulicht ist in der Lage, einen Messsensor, zum Beispiel die Auftrefffläche der Photodiode, gleichmässig auszuleuchten.

Die Diffusorfläche kann an einem optischen Element angeordnet sein, so dass das Streulicht direkt als diffuses Licht abgegeben wird, oder die Diffusorfläche kann als Reflektionsfläche vorgeshen sein, die gerichtetes und/oder diffuses Streulicht empfängt und diffuses Streulicht abgibt.

Das Streulicht kann dabei gleichzeitig in eine bestimmmte Raumrichtung gelenkt werden, so dass die Photodiode optimal getroffen wird.

Die Photodiode ist derartig angeordnet, dass im Wesentlichen nur von einer Diffusorfläche emittiertes Streulicht auf die Photodiode trifft.

Als Diffusorfläche kann jede aufgeraute Fläche innerhalb des Lichtmoduls wirken. Bevorzugt wird als Diffusorfläche eine matte metallische Fläche verwendet, um das Streulicht umzulenken und zu homogenisieren.

Die Rauigkeit wird so gewählt, dass die Lichtintensität des emittierten Streulichts zur Detektierung an der Photodiode aus-reicht.

Es kann ein Flächenabschnitt des Gehäuses als Diffusorfläche verwendet werden. Die Gehäusefläche kann dazu aufgeraut sein, beispielsweise bereits bei der Herstellung in einer vorstrukturierten Gussform gefertigt werden, oder die Gehäusefläche kann nachstrukturiert werden, zum Beispiel durch Aufrauen, Lackieren, Aufbringen eines Aufklebers oder andere Massnahmen.

Die Diffusorfläche und die Photodiode sind bevorzugt so angeordnet, dass Streulicht zunächst auf die Diffusorfläche trifft und von dort auf die Photodiode gelangt.

In einer vorteilhaften Ausbildung der Erfindung umfasst das Lichtmodul eine Strahlformungsvorrichtung, die zur Formung der kombinierten Strahlung im Lichtmodul angeordnet ist. Es kann zum Beipsiel ein Prismenteleskop vorgesehen sein. Die Photodiode ist vorteilhafterweise so angeordnet, dass Streulicht von der Strahlformungsvorrichtung auf die Photodiode trifft. Dabei kann das Streulicht der Strahlformungsvorrichtung direkt auf die Photodiode gelangen oder das Streulicht kann von der Strahlformungsvorrichtung auf eine Diffusorfläche und von dort auf die Photodiode treffen.

Mindestens eine Oberfläche der Strahlformungsvorrichtung ist beispielsweise mit einem Antrireflexcoating versehen, sodass 0.1-0.2%, bevorzugt maximal 0.5% des aufgenommen Lichts als Streulicht abgegeben werden.

Das Streulicht kann von der Photodiode detektiert werden und reicht aus, um Informationen über die Qualität des primären Strahls zu erhalten. Geht das Streulicht von der Strahlformungsvorrichtung aus, so enthält es Information über den kombinierten Strahl.

Vorteilhafterweise sind die Laserdioden in einer Diodenhalterung, bevorzugt nebeneinander, angeordnet. Die Photodiode ist ebenfalls an dieser Diodenhalterung angeordnet.

Die Elemente sind somit leicht zu einem Lichtmodul montierbar, können beispielweise zusammen in einem Schritt auf eine Trägerplatte montiert werden. Der Ausgang der Photodiode liegt in der Nähe der Laserdioden, und eine Steuerung und/oder Regelung der Laserdioden auf Basis des Photosignals an der Photodiode lässt sich leicht verschalten. Hierbei sind insbesondere die Absätnde sehr kurz, so dass auch die Leiterbahnen sehr kurz gehalten werden können.

Bevorzugt sind die Laserdioden direkt nebeneinander angeordnet und die Photodiode ist als Randelement angeordnet, sodass die Photodiode nur eine Laserdiode als Nachbarn hat. Bevorzugt ist die Photodiode neben der Laserdiode angeordnet, die am nächsten zum Austrittsfester des Lichtmoduls und damit zum Ende des bestimmungsgemässen Lichtpfades angeordnet ist. Streulicht, das Licht aller Laserdioden umfasst, kann dann einen eher kurzen Weg zu der Photodiode nehmen.

Vorteilhafterweise umfasst die Diodenhalterung eine abgeschrägte Fläche, die bevorzugt im montierten Zustand in Strahlausbreitungsrichtung nach der Strahlkombinationsvorrichtung angeordnet ist. Die abgeschrägte Fläche ist als Diffusorfläche ausgebildet ist.

Die abgeschrägte Fläche dient daher zum Leiten und Homonogenisieren des Streulichts, das an oder nach der Strahlkombinationsvorrichtung emittiert wird und somit Aufschluss über den kombinierten Lichtstrahl aller Lichtdioden erlaubt.

Die abgeschrägte Fläche weist bevorzugt eine rauhere Oberfläche auf, als die anderen Flächen der Diodenhalterung.

Bevorzugt ist die Photodiode derartig angeordnet, dass Streulicht detektierbar ist, welches Licht von allen Laserdioden umfasst. Die Photodiode ist zum Beispiel so angeordnet, dass Streulicht, welches in Strahlausbreitungsrichtung an oder nach der Strahlkombinationsvorrichtung emittiert wird, direkt auf die Photodiode trifft oder die Photodiode ist so angeordnet, dass Streulicht, welches in Strahlausbreitungsrichtung an oder nach der Strahlkombinationsvorrichtung emittiert wird über eine Diffusorfläche reflektiert wird und dann auf die Photodiode trifft.

In einer vorteilhaften Ausführung der Erfindung umfasst das Lichtmodul ein Austrittsfenster, welches bevorzugt gleichzeitig als Streulichtemitter wirkt. Die Photodiode ist vorteilhafterweise derartig angeordnet, dass Streulicht von dem Austrittsfenster auf die Photodiode trifft. Dabei kann das Streulicht vom Austrittsfenster direkt auf die Photodiode gelangen oder das Streulicht kann von dem Austrittsfenster auf eine Diffusorfläche und von dort auf die Photodiode treffen.

Das Austrittsfenster, dessen bestimmungsgemässer Lichtpfad durch die Fensterfläche hindurch führt, kann mit einer Beschichtung versehen sein. Das Austrittsfenster ist bevorzugt senkrecht zur optischen Achse des Primärstrahls ausgerichtet. Es kann jedoch auch gegenüber dieser Lage leicht geneigt sein, um Streulicht gezielt in Richtung Photodiode oder Diffusorfläche zu emittieren.

Die Aufgabe wird ausserdem durch ein Verfahren zur Überwachung von Laserdioden in einem Lichtmodul, insbesondere einem Lichtmodul wie oben beschrieben, gelöst, welches die folgenden Schritte umfasst:
Laserstrahlung wird aus mindestens zwei, bevorzugt drei, Laserdioden, emittiert.

Die Laserstrahlung aus den Laserdioden wird durch eine Kollimierungsvorrichtung kollimiert, wobei insbesondere für jede Laserdiode eine Kollimiervorrichtung vorgesehene ist.

Die Laserstrahlung aus den Laserdioden wird durch eine Strahlkombinationsvorrichtung zu einem kombinierten Strahl kombiniert.

Insbesondere werden die von den Laserdioden emittieren Strahlen jeweils von einem dichroitischen Filter umgelenkt und mit den übrigen Strahlen zusammengeführt.

Eine Photodiode detektiert in dem Lichtmodul vorhandenes Streulicht, wobei ausschliesslich Streulicht auf die Photodiode fällt.

Bevorzugt wird der kombinierte Strahl von einer Strahlformungsvorrichtung geformt. Alternativ können die einzelnen von den Laserdioden erzeugten Strahlen von jeweils einer Strahlformungsvorrichtung geformt werden.

Erfindungsgemäss wird das detektierte Streulicht von einer Diffusorfläche emittiert.

Besonders bevorzugt trifft Streulicht auf die Diffusorfläche und von dort auf die Photodiode.

Vorteilhafterweise wird das Streulicht durch mindestens eine Strahlformungsvorrichtung für die kombinierte Strahlung abgegeben.

In einer vorteilhaften Variante des Verfahrens wird das Streulicht durch eine Photodiode detektiert, die neben einer Laserdiode angeordnet ist.

Die Diffusorfläche kann insbesondere durch eine abgeschrägte Fläche einer Diodenhalterung gebildet werden und das detektierte Streulicht durch diese abgeschrägte Fläche der Diodenhalterung abgebgeben.

Bevorzugt detektiert die Photodiode Streulicht von allen Laserdioden.

Vorteilhafterweise detektiert die Photodiode Streulicht von einem Austrittsfenster.

Im Folgenden wird die Erfindung in Ausführungsbeispielen näher erläutert. Hierbei zeigt
- Fig. 1: eine schematische Darstellung eines ersten Beispiels für ein Lichtmodul;
- Fig. 2: eine schematische Darstellung eines zweiten Beispiels für ein Lichtmödul;
- Fig. 3: eine schematische Darstellung eines dritten Beispiels für ein Lichtmodul.

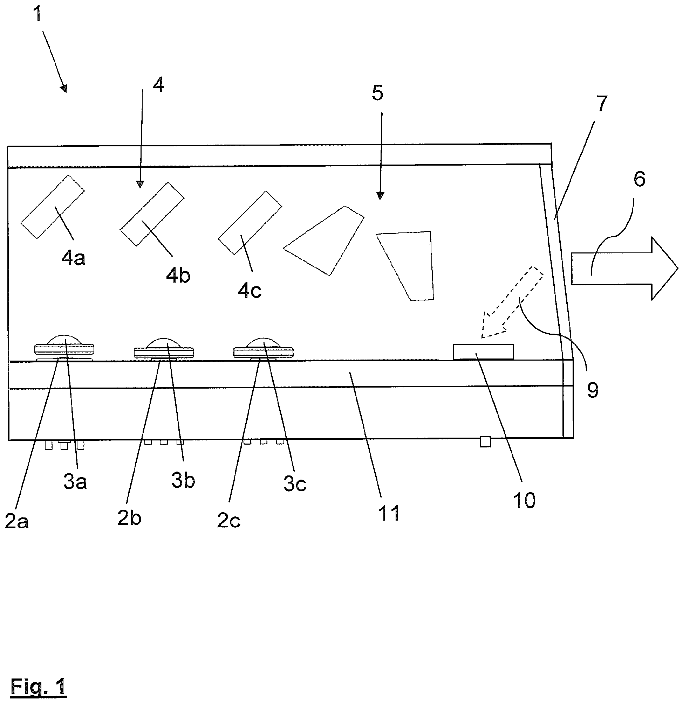

Figur 1 zeigt eine schematische Darstellung eines ersten Beispiels für ein Lichtmodul 1 in Aufsicht.

Das Lichtmodul 1 umfasst drei Laserdioden 2a, 2b, 2c, die Wellenlängen im roten, grünen und blauen Wellenlängenbereich emittieren.

Jeder Laserdiode 2a, 2b, 2c ist eine Kollimierungsvorrichtung 3a, 3b, 3c zugeordnet.

Die von den Laserdioden 2a, 2b, 2c emitterten Strahlen werden von einer Strahlkombinationsvorrichtung 4 zusammengeführt, im vorliegende Fall von je einem dichroitischen Filter 4a, 4b, 4c, der das Licht mit den Wellenlängen der im zugeordneten Laserdiode 2a, 2b, 2c umlenkt und die übrigen Wellenlängen durchleitet.

Das Lichtmodul umfasst ausserdem eine Strahlformungseinrichtung 5 in Form eines Prismenteleskops.

Der primäre Lichtstrahl 6 des Lichtmoduls ist nach der Strahlformungseinrichtung eine Kombination aus den Lichtstrahlen aller Laserdioden mit rundem Querschnitt. Er kann nun auf einen nicht in der Figur dargestellten MEMS-Spiegel treffen und zur Bildprojektion genutzt werden.

Im gezeigten Beispiel besitzt das Lichtmodul 1 ein Austrittsfenster 7, dessen eine Oberfläche Streulicht emittiert.

Während der Grossteil des geformten Lichtstrahls als primärer Lichtstrahl 6 das Lichtmodul 1 verlässt, wird ein kleiner Teil des Lichtstrahls als Streulicht 9 an dem Austrittsfenster 7 reflektiert. Das Streulicht 9 trifft dann auf eine Photodiode 10. Diese ist so angeordnet, dass nur Streulicht 9 von dem Austrittsfenster 7 auf die Photodiode 10 trifft. Das Austrittsfenster 7 kann dafür leicht schräg ausgerichtet sein.

Die Photodiode 10 liegt nicht im Strahlgang der optischen Komponenten des Lichtmoduls 1 und es gelangt nichts von dem Licht, das bei bestimmungsgemässem Lichtverlauf die optischen Komponenten passiert, auf die Photodiode 10.

Das Streulicht 9 ist Verlustlicht, das dem primären Lichtstrahl ohnehin fehlt. Es reicht aus, um Informationen über die Qualität des primären Lichtstrahls zu erhalten. Abhängig von z.B. von den Umgebungsbedingungen oder von der Betriebszeit kann es Schwenkungen in der Gesamtintensität geben, die sich auch in dem Streulicht widerspiegeln.

Die aus dem Streulicht 9 gewonnen Information lässt sich daher zum Nachregeln oder Nachjustieren der Laserdioden 2a, 2b, 2c oder der optischen Komponenten nutzen.

Die Laserdioden 2a, 2b, 2c sind nebeneinander in einer Diodenhalterung 11 angeordnet. Die Photodiode 10 ist ebenfalls an dieser Diodenhalterung 11 angeordnet, sodass bei der Montage des Lichtmoduls die Laserdioden 2a, 2b, 2c und die Photodiode 10 gemeinsam in einem Schritt in dem Gehäuse platziert werden können.

Diese Anordnung kann gewählt werden, wenn die Photodiode 10 einen ähnlichen Aufbau wie die Laserdioden 2a, 2b, 2c aufweist. Photodioden mit einer anderen Bauform, beispielweise SMD Photodioden, werden bevorzugt direkt auf einer gedruckten Leiterplatte angebracht, an welcher auch die Laserdioden angelötet werden.

Die Photodiode 10 ist im Wesentlichen neben einer äusseren Laserdiode 2c, die nur eine benachbarte Laserdiode 2b hat, angeordnet.

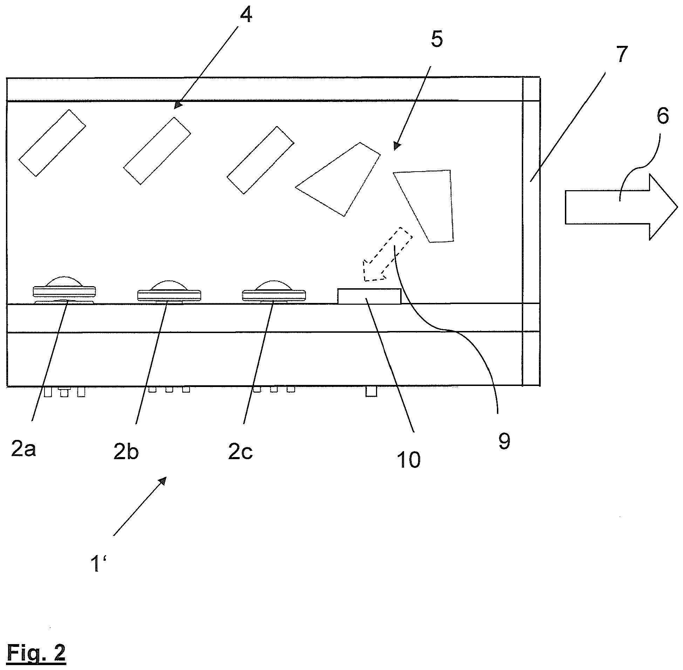

Figur 2 zeigt eine schematische Darstellung eines zweiten Beispiels für ein Lichtmodul 1' in Aufsicht, dessen primärer Lichtstrahl 6 den gleichen Verlauf von den Laserdioden 2a, 2b, 2c, über die Strahlkombinationsvorrichtung 4, die Strahlformungseinrichtung 5 und durch das Austrittsfenster 7 nimmt, wie im ersten Beispiel.

Die Photodiode 10 ist allerdings so angeordnet, dass Streulicht 9 von der Strahlformungseinrichtung 5 auf die Photodiode 10 trifft.

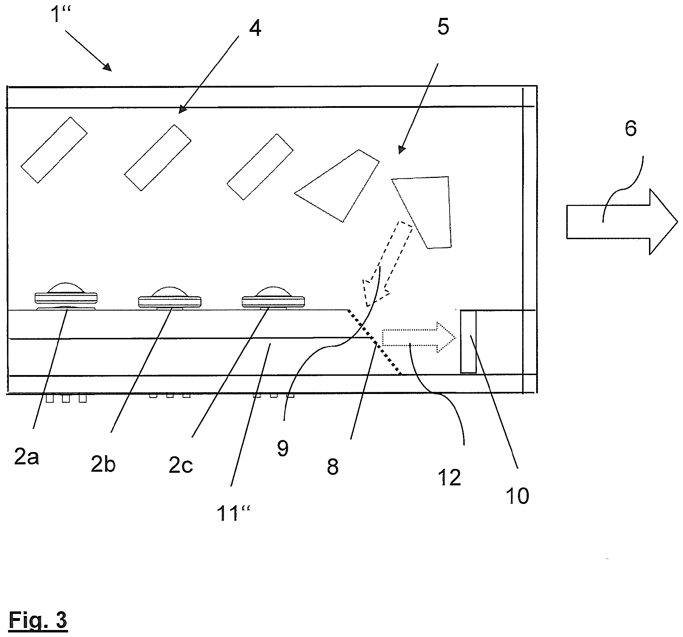

Figur 3 zeigt eine schematische Darstellung eines dritten Beispiels für ein Lichtmodul 1" in Aufsicht, dessen primärer Lichtstrahl 6 den gleichen Verlauf von den Laserdioden 2a, 2b, 2c, über die Strahlkombidationsvorrichtung 4, die Strahlformungseinrichtung 5 und durch das Austrittsfenster 7 nimmt, wie in den vorangehenden Beispielen.

An der Diodenhalterung 11" ist eine Diffusorfläche 8 vorgesehen, auf welche Streulicht 9 von der Strahlformungseinrichtung 5 trifft.

Von der Diffusorfläche 8 wird diffuses Licht 12 auf die Photodiode geleitet.

## Patentansprüche

1. Lichtmodul zur Erzeugung von mehrfarbigem Licht, umfassend mindestens zwei, bevorzugt drei, Laserdioden (2a, 2b, 2c), jeweils eine Kollimierungsvorrichtung (3a, 3b, 3c) pro Laserdiode (2a, 2b, 2c) zur Kollimierung der emittierten Strahlung der jeweiligen Laserdiode (2a, 2b, 2c), eine Strahlkombinationsvorrichtung (4) zum Kombinieren der emittierten Strahlung aus den jeweiligen Laserdioden (2a, 2b, 2c), eine Photodiode (10) zur Überwachung der von den Laserdioden (2a, 2b, 2c) emittierten Strahlung und insbesondere eine Strahlformungseinrichtung (5), wobei die Photodiode (10) derartig angeordnet ist, dass nur Streulicht (9, 12), welches als parasitäres Licht vom bestimmungsgemässen Lichtpfad des Lichtmoduls weggelenkt wird, auf die Photodiode (10) trifft, und wobei die Photodiode sich nicht im Strahlweg des Lichtmoduls befindet und keine optische Komponente vorgesehen ist, die nur dazu dient, einen Teil des primären Lichtstrahls in Richtung Photodiode abzuzweigen, **dadurch gekennzeichnet, dass** das Lichtmodul mindestens eine Diffusorfläche (8) zur Abgabe von homogenisiertem Streulicht (12) umfasst, wobei die Photodiode (10) derartig angeordnet ist, dass im Wesentlichen nur von einer Diffusorfläche (8) emittiertes Streulicht (12) auf die Photodiode (10) trifft.

2. Lichtmodul nach Anspruch 1, **dadurch gekennzeichnet, dass** das Lichtmodul (1) eine Strahlformungsvorrichtung (5) umfasst, die zur Formung der kombinierten Strahlung im Lichtmodul (1, 1', 1") angeordnet ist, und die Photodiode (10) derartig angeordnet ist, dass Streulicht (9, 12) von der Strahlformungsvorrichtung (5) auf die Photodiode (10) trifft.

3. Lichtmodul nach einem der vorhergehenden Ansprüche, **dadurch gekennzeichnet, dass** die Laserdioden (2a, 2b, 2c) in einer Diodenhalterung (11, 11"), bevorzugt nebeneinander, angeordnet sind und die Photodiode (10) ebenfalls an dieser Diodenhalterung (11, 11") angeordnet ist und/oder die Photodiode (10) im Wesentlichen neben einer äusseren Laserdiode (2c) angeordnet ist.

4. Lichtmodul nach Anspruch 3, **dadurch gekennzeichnet, dass** die Diodenhalterung (11") eine abgeschrägte Fläche umfasst, die in Strahlausbreitungsrichtung bevorzugt nach der Strahlkombinationsvorrichtung (4) angeordnet ist, wobei die abgeschrägte Fläche als Diffusorfläche (8) ausgebildet ist und bevorzugt eine rauhere Oberfläche aufweist, als die anderen Flächen der Diodenhalterung (11").

5. Lichtmodul nach einem der vorhergehenden Ansprüche, **dadurch gekennzeichnet, dass** die Photodiode (10) derartig angeordnet ist, dass Streulicht (9, 12) detektierbar ist, welches Licht von allen Laserdioden (2a, 2b, 2c) enthält.

6. Lichtmodul nach einem der vorhergehenden Ansprüche, **dadurch gekennzeichnet, dass** das Lichtmodul (1, 1', 1") ein Austrittsfenster (7) umfasst, und die Photodiode (10) derartig angeordnet ist, dass Streulicht (9, 12) von dem Austrittsfenster (7) auf die Photodiode (10) trifft.

7. Verfahren zur Überwachung von Laserdioden in einem Lichtmodul, insbesondere einem Lichtmodul gemäss einem der vorhergehenden Ansprüche, umfassend die Schritte
- Emittieren von Laserstrahlung aus mindestens zwei, bevorzugt drei, Laserdioden(2a, 2b, 2c),
- Kollimieren der Laserstrahlung aus den Laserdioden (2a, 2b, 2c) durch eine Kollimierungsvorrichtung (3a, 3b, 3c),
- Kombinieren der Laserstrahlung aus den Laserdioden(2a, 2b, 2c) zu einem kombinierten Strahl durch eine Strahlkombinationsvorrichtung (4),
- Detektieren von Streulicht (9, 12), welches als parasitäres Licht vom bestimmungsgemässen Lichtpfad des Lichtmoduls weggelenkt wird, durch eine Photodiode (10), die sich nicht im Strahlweg des Lichtmoduls befindet, wobei ausschliesslich Streulicht (9, 12) auf die Photodiode (10) fällt, wobei keine optische Komponente vorgesehen ist, die nur dazu dient, einen Teil des primären Lichtstrahls in Richtung Photodiode abzuzweigen,
**dadurch gekennzeichnet, dass** das Streulicht (12) von einer Diffusorfläche (8) emittiert wird.

8. Verfahren nach Anspruch 7, **dadurch gekennzeichnet, dass** das Streulicht (9) von einer Strahlformungsvorrichtung (5) für die kombinierte Strahlung abgegeben wird.

9. Verfahren nach einem der vorhergehenden Ansprüche 7 oder 8, **dadurch gekennzeichnet, dass** das Streulicht (9, 12) durch eine Photodiode (10) detektiert wird, die neben einer Laserdiode (2c) angeordnet ist.

10. Verfahren nach einem der vorhergehenden Ansprüche 7 bis 9, **dadurch gekennzeichnet, dass** die Diffusorfläche (8) durch eine abgeschrägte Fläche einer Diodenhalterung (11") gebildet wird und dass Streulicht (12) durch diese abgeschrägte Fläche der Diodenhalterung (11") abgegeben wird.

11. Verfahren nach einem der Ansprüche 7 bis 10, **dadurch gekennzeichnet, dass** die Photodiode (10) Streulicht (9, 12) detektiert, das Licht von allen Laserdioden (2a, 2b, 2c) enthält.

12. Verfahren nach einem der Ansprüche 7 bis 11, **dadurch gekennzeichnet, dass** die Photodiode (10) Streulicht (9, 12) detektiert, welches von einem Austrittsfenster (7) abgegeben wird.

## Claims

1. Light module for generating multicolor light, comprising at least two, preferably three, laser diodes (2a, 2b, 2c), one collimation device (3a, 3b, 3c) per laser diode (2a, 2b, 2c) for collimating the emitted radiation from the respective laser diode (2a, 2b, 2c), a beam combining device (4) for combining the emitted radiation from the respective laser diodes (2a, 2b, 2c), a photodiode (10) for monitoring the radiation emitted by the laser diodes (2a, 2b, 2c) and, in particular, a beam-shaping device (5), the photodiode (10) being arranged in such a way that only scattered light (9, 12), which is deflected as parasitic light away from the intended light path of the light module, impinges on the photodiode (10), and the photodiode not being located in the beam path of the light module and no optical component being provided which serves only to branch off part of the primary light beam in the direction of the photodiode, **characterized in that** the light module comprises at least one diffuser surface (8) for emitting homogenized scattered light (12), the photodiode (10) being arranged in such a way that substantially only scattered light (12) emitted from a diffuser surface (8) impinges on the photodiode (10) .

2. Light module according to claim 1, **characterized in that** the light module (1) comprises a beam shaping device (5) arranged in the light module (1, 1', 1'') for shaping the combined radiation, and the photodiode (10) is arranged such that scattered light (9, 12) from the beam shaping device (5) impinges on the photodiode (10).

3. Light module according to one of the preceding claims, **characterized in that** the laser diodes (2a, 2b, 2c) are arranged in a diode holder (11, 11''), preferably next to each other, and the photodiode (10) is also arranged on this diode holder (11, 11'') and/or the photodiode (10) is arranged essentially next to an outer laser diode (2c).

4. Light module according to claim 3, **characterized in that** the diode holder (11'') comprises a bevelled surface which is preferably arranged downstream of the beam combining device (4) in the beam propagation direction, the bevelled surface being formed as a diffuser surface (8) and preferably having a rougher surface than the other surfaces of the diode holder (11'') .

5. Light module according to one of the preceding claims, **characterized in that** the photodiode (10) is arranged in such a way that scattered light (9, 12) containing light from all laser diodes (2a, 2b, 2c) is detectable.

6. Light module according to one of the preceding claims, **characterized in that** the light module (1, 1', 1'') comprises an exit window (7), and the photodiode (10) is arranged in such a way that scattered light (9, 12) from the exit window (7) impinges on the photodiode (10).

7. Method for monitoring laser diodes in a light module, in particular a light module according to one of the preceding claims, comprising the steps of
- Emitting laser radiation from at least two, preferably three, laser diodes (2a, 2b, 2c),
- collimating the laser radiation from the laser diodes (2a, 2b, 2c) by a collimating device (3a, 3b, 3c),
- combining the laser radiation from the laser diodes (2a, 2b, 2c) into a combined beam by a beam combining device (4),
- detecting scattered light (9, 12), which is deflected as parasitic light away from the intended light path of the light module, by a photodiode (10) which is not located in the beam path of the light module, wherein exclusively scattered light (9, 12) falling on the photodiode (10), no optical component being provided which serves only to branch off a part of the primary light beam in the direction of the photodiode,
**characterized in that** the scattered light (12) is emitted from a diffuser surface (8).

8. Method according to claim 7, **characterized in that** the scattered light (9) is emitted from a beam shaping device (5) for the combined radiation.

9. Method according to any one of the preceding claims 7 or 8, **characterized in that** the scattered light (9, 12) is detected by a photodiode (10) arranged adjacent to a laser diode (2c).

10. Method according to any one of the preceding claims 7 to 9, **characterized in that** the diffuser surface (8) is formed by a beveled surface of a diode holder (11'') and that scattered light (12) is emitted through this beveled surface of the diode holder (11'').

11. Method according to any one of claims 7 to 10, **characterized in that** the photodiode (10) detects scattered light (9, 12) containing light from all laser diodes (2a, 2b, 2c) .

12. Method according to any one of claims 7 to 11, **characterized in that** the photodiode (10) detects scattered light (9, 12) emitted from an exit window (7).

## Revendications

1. Module lumineux pour la production de lumière multicolore, comprenant au moins deux, de préférence trois, diodes laser (2a, 2b, 2c), respectivement un dispositif de collimation (3a, 3b, 3c) par diode laser (2a, 2b, 2c) pour collimater le rayonnement émis par la diode laser respective (2a, 2b, 2c), un dispositif de combinaison de faisceaux (4) pour combiner le rayonnement émis par les diodes laser respectives (2a, 2b, 2c), une photodiode (10) pour surveiller le rayonnement émis par les diodes laser (2a, 2b, 2c) et en particulier un dispositif de formation de faisceau (5), la photodiode (10) étant disposée de telle sorte que seule la lumière diffusée (9, 12), qui est déviée en tant que lumière parasite du trajet de lumière conforme du module de lumière, rencontre la photodiode (10), et la photodiode ne se trouvant pas dans le trajet de faisceau du module de lumière et aucun composant optique n'étant prévu, qui sert uniquement à dévier une partie du faisceau lumineux primaire en direction de la photodiode,
**caractérisé en ce que** le module lumineux comprend au moins une surface de diffusion (8) pour l'émission d'une lumière diffusée homogénéisée (12), la photodiode (10) étant disposée de telle sorte que seule la lumière diffusée (12) émise essentiellement par une surface de diffusion (8) atteint la photodiode (10).

2. Module lumineux selon la revendication 1, **caractérisé en ce que** le module lumineux (1) comprend un dispositif de formation de faisceau (5) disposé dans le module lumineux (1, 1', 1'') pour former le rayonnement combiné, et la photodiode (10) est disposée de telle sorte que la lumière diffusée (9, 12) provenant du dispositif de formation de faisceau (5) est incidente sur la photodiode (10).

3. Module lumineux selon l'une des revendications précédentes, **caractérisé en ce que** les diodes laser (2a, 2b, 2c) sont disposées dans un support de diodes (11, 11''), de préférence les unes à côté des autres, et la photodiode (10) est également disposée sur ce support de diodes (11, 11'') et/ou la photodiode (10) est disposée sensiblement à côté d'une diode laser extérieure (2c).

4. Module lumineux selon la revendication 3, **caractérisé en ce que** le support de diode (11'') comprend une surface inclinée qui est disposée de préférence après le dispositif de combinaison de faisceaux (4) dans la direction de propagation du faisceau, la surface inclinée étant conçue comme une surface de diffuseur (8) et présentant de préférence une surface plus rugueuse que les autres surfaces du support de diode (11'').

5. Module lumineux selon l'une des revendications précédentes, **caractérisé en ce que** la photodiode (10) est disposée de telle sorte que la lumière diffusée (9, 12) contenant la lumière de toutes les diodes laser (2a, 2b, 2c) puisse être détectée.

6. Module lumineux selon l'une des revendications précédentes, **caractérisé en ce que** le module lumineux (1, 1', 1'') comprend une fenêtre de sortie (7) et la photodiode (10) est disposée de telle sorte que la lumière diffusée (9, 12) provenant de la fenêtre de sortie (7) est incidente sur la photodiode (10).

7. Procédé de surveillance de diodes laser dans un module de lumière, en particulier un module de lumière selon l'une des revendications précédentes, comprenant les étapes suivantes
- Émission d'un rayonnement laser à partir d'au moins deux, de préférence trois, diodes laser (2a, 2b, 2c),
- Collimation du rayonnement laser provenant des diodes laser (2a, 2b, 2c) par un dispositif de collimation (3a, 3b, 3c),
- combiner le rayonnement laser provenant des diodes laser (2a, 2b, 2c) en un faisceau combiné par un dispositif de combinaison de faisceaux (4),
- détection de la lumière diffusée (9, 12), qui est déviée en tant que lumière parasite du chemin lumineux prévu du module de lumière, par une photodiode (10) qui ne se trouve pas sur le chemin du faisceau du module de lumière, seule la lumière diffusée (9, 12) tombe sur la photodiode (10), aucun composant optique n'étant prévu, lequel sert uniquement à dévier une partie du faisceau lumineux primaire en direction de la photodiode,
**caractérisé en ce que** la lumière diffusée (12) est émise par une surface de diffusion (8).

8. Procédé selon la revendication 7, **caractérisé en ce que** la lumière diffusée (9) est émise par un dispositif de formation de faisceau (5) pour le rayonnement combiné.

9. Procédé selon l'une des revendications précédentes 7 ou 8, **caractérisé en ce que** la lumière diffusée (9, 12) est détectée par une photodiode (10) disposée à côté d'une diode laser (2c).

10. Procédé selon l'une des revendications précédentes 7 à 9, **caractérisé en ce que** la surface de diffusion (8) est formée par une surface biseautée d'un support de diode (11") et **en ce que** la lumière diffusée (12) est émise par cette surface biseautée du support de diode (11").

11. Procédé selon l'une des revendications 7 à 10, **caractérisé en ce que** la photodiode (10) détecte une lumière diffusée (9, 12) contenant de la lumière provenant de toutes les diodes laser (2a, 2b, 2c).

12. Procédé selon l'une des revendications 7 à 11, **caractérisé en ce que** la photodiode (10) détecte la lumière diffusée (9, 12) émise par une fenêtre de sortie (7).
